# EUROPEAN PATENT SPECIFICATION

(11) **EP 1 953 808 B1**
(45) Date of publication and mention of the grant of the patent: **26.09.2018**
(21) Application number: 06822227.2
(22) Date of filing: 25.10.2006
(51) Int. Cl.: H01L 21/205, C23C 16/24, H01L 21/02

(54) **METHOD FOR MANUFACTURING EPITAXIAL WAFER**
VERFAHREN ZUR HERSTELLUNG EINES EPITAXIALWAFERS
PROCEDE DE PRODUCTION D'UNE PLAQUETTE EPITAXIALE

(30) Priority: 22.11.2005 JP 2005337160
(43) Date of publication of application: 06.08.2008
(73) Proprietor: Shin-Etsu Handotai Co., Ltd., Tokyo (JP)
(72) Inventor: KANAYA, Koichi, Nishishirakawa-gun Fukushima 961-8061 (JP); OHNISHI, Masato, Nishishirakawa-gun Fukushima 961-8061 (JP)
(74) Representative: Wibbelmann, Jobst
(86) International application number: PCT/JP2006/321250
(87) International publication number: WO 2007/060806

(56) References cited:
- JP-A- 2000 349 030
- JP-A- 2003 142 434
- JP-A- 2003 282 580
- JP-A- 2003 332 183
- Seshan, Krishna: "Handbook of Thin-Film Deposition Processes and Techniques - Processes and Technologies" 1 January 2002 (2002-01-01), Noyes Publications , Norwich, USA , XP002606090 ISBN: 0-8155-1442-5pages 60-67, * page 60 - page 67 *

## Description

### TECHNICAL FIELD

The present invention relates to a method for manufacturing an epitaxial wafer.

### BACKGROUND ART

When fabricating a semiconductor device, an epitaxial wafer having an epitaxial layer formed on a silicon wafer may be used in some cases. The epitaxial wafer can be generally manufactured by introducing a raw material gas (e.g., SiCl₄ or SiHCl₃) into a reactor and growing a silicon single crystal layer (an epitaxial layer) on a silicon single crystal wafer heated to a high temperature.

Film thickness uniformity of the epitaxial layer is one of the most important quality items of the epitaxial wafer, and generally evaluated by an optical measurement method using an infrared ray. Further, a thickness uniformity (flatness) of the entire epitaxial wafer is evaluated by a technique using an electric capacitance or an optical displacement gauge as a fundamental principle.

However, in shape measurement based on these methods, an outer peripheral shape outside from an edge of a wafer than 3 mm cannot be accurately measured because of limitations in principle and structure of an apparatus. Therefore, a discussion concerning the film thickness uniformity of the epitaxial layer is mainly concentrated on a portion inside from the edge than 5 mm, and the film thickness uniformity near the outermost periphery close to the edge of the wafer has not attracted attention.

However, from a viewpoint of miniaturization of a semiconductor device or expansion of a device fabrication region in recent years, a high flatness degree near the outermost periphery of a wafer has been demanded, and a concern about a flatness degree or a surface displacement amount near the outermost periphery of a wafer is growing. Furthermore, an apparatus that measures a surface shape of a wafer near the outermost periphery has been developed, and an index called an edge roll-off (which may be simply referred to as a roll-off in some cases) quantitatively indicative of a sag amount and a rise amount of the outermost peripheral portion of a wafer is recently used to evaluate a shape of the outermost periphery of the wafer.

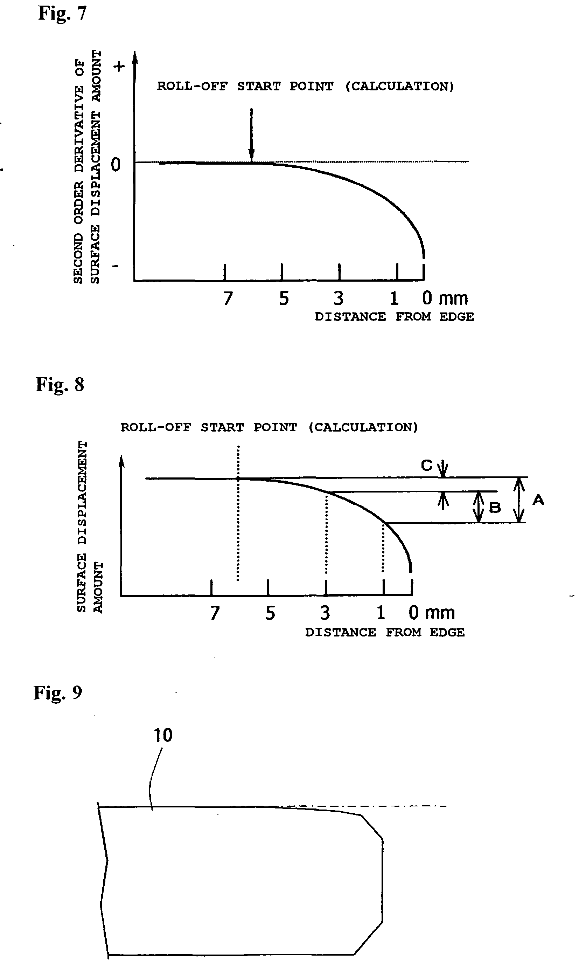

For example, in case of a silicon wafer having a diameter of 300 mm (a radius of 150 mm), a height displacement amount (B in Fig. 8) of a surface between positions which are 147 to 149 mm from the center of the wafer may be determined as a roll-off or a surface displacement amount (A, C in Fig. 8) from a position where a surface shape of the wafer starts to change into a sagging shape at an accelerating pace to a predetermined position close to an edge may be determined as a roll-off to be evaluated.

For example, as shown in Fig. 7, a distribution of a second order derivative of a surface displacement amount at a peripheral portion of a wafer is calculated, and a surface displacement amount (A in Fig. 8) from a position where the second order derivative of the surface displacement amount becomes a negative value (a roll-off start point) to a position that is 149 mm from the center of the wafer, i.e., 1 mm inside from an edge is determined as a roll-off to be evaluated. In this case, a height at the roll-off start point is set to 0, and the displacement amount (a roll-off) has a negative value in case of a sagging shape reaching the position that is 1 mm inside from the edge, but the displacement amount has a positive value in case of a rising shape. Furthermore, it can be evaluated that a flatness degree is high even near the outermost periphery when an absolute value of the roll-off is small.

Various methods for manufacturing a silicon wafer having a small roll-off have been proposed. For example, when a silicon wafer is polished, a peripheral portion of the wafer is excessively polished, and the peripheral portion of the wafer is apt to have a sagging shape as shown in Fig. 9. Thus, a method of forming, e.g., an oxide film having a low polishing rate at a chamfered portion only and then performing double-side polishing has been proposed (see Japanese Patent Application Laid-open No. 2003-142434). According to such a method, excessive polishing can be avoided at a peripheral portion of a wafer, and a silicon wafer having a small roll-off can be manufactured.

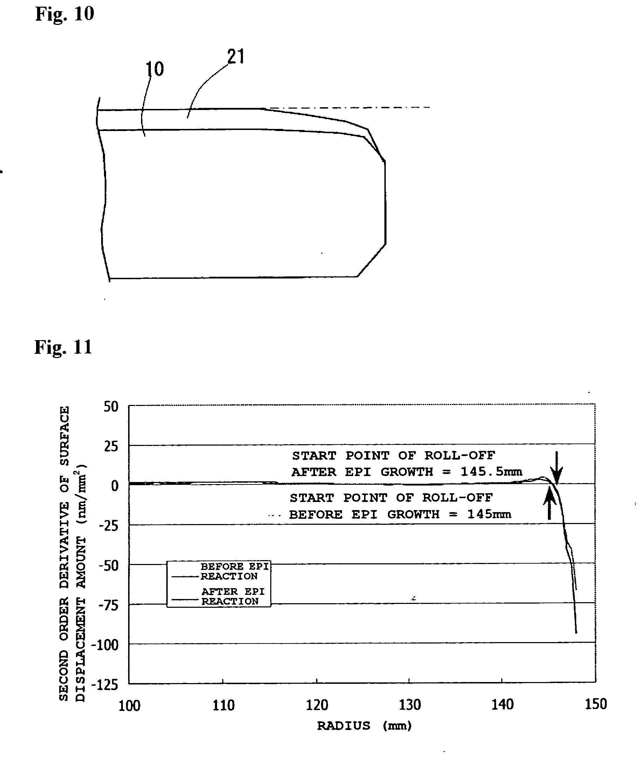

In recent years, a demand for standardization of a roll-off has extended to an epitaxial wafer, and controlling outer peripheral shapes of an epitaxial layer and an epitaxial wafer is desired. However, in a conventional epitaxial growth technology, a thickness of an epitaxial layer 21 may be reduced near the outermost periphery in some cases as shown in Fig. 10, and there is a problem that a roll-off is degraded due to an epitaxial growth process as compared with that of a silicon wafer 10 before epitaxial growth.

As a method for manufacturing an epitaxial wafer having a high flatness degree even near the outermost periphery, a method of using a grinding stone to perform diameter reduction chamfering or using a laser to carry out fusion cutting with respect to a peripheral portion after epitaxial growth has been proposed (see Japanese Patent Application Laid-open No. 2003-332183).

JP 2000-349030 A discloses a method for manufacturing an epitaxial wafer by supplying a raw material gas onto a silicon wafer to perform vapor-phase growth of an epitaxial layer.

However, this method has a problem that particle generation or cracks may possibly occur due to diameter reduction chamfering or fusion cutting after epitaxial growth and a wafer becomes small in size because the wafer is subjected to diameter reduction or fusion cutting after epitaxial growth, thereby substantially considerably degrading productivity or a yield ration.

### DISCLOSURE OF INVENTION

In view of the above-explained problem, it is an object of the present invention to provide a method that enables manufacturing an epitaxial wafer having a small roll-off value by controlling a thickness of an epitaxial layer near the outermost periphery at the time of epitaxial growth.

To achieve this object, according to the present invention, there is provided a method for manufacturing an epitaxial wafer by supplying a raw material gas onto a silicon wafer to perform vapor-phase growth of an epitaxial layer, wherein a a correlation between a growth rate and/or a growth temperature of the epitaxial layer and a difference between roll-offs before and after growth of the epitaxial layer is obtained in advance, and a roll-off after growth of the epitaxial layer is controlled by controlling the growth rate and/or the growth temperature of the epitaxial layer that is grown on the silicon wafer to be a product based on the correlation, wherein the roll-off is a surface displacement amount from a position where a second order derivative of a surface displacement amount of the silicon wafer or the epitaxial wafer becomes a negative value to a position that is 1 mm inside from an edge of the silicon wafer or the epitaxial wafer.

As will be explained later, the present inventors have discovered that a growth rate and growth temperature of the epitaxial layer and a thickness of the epitaxial layer that is formed at the peripheral portion of the wafer have an excellent correlation. Thus, controlling the growth rate and/or the growth temperature of the epitaxial layer as explained above enables controlling the thickness of the epitaxial layer that is formed at the peripheral portion of the silicon wafer, thereby manufacturing the epitaxial layer having a small roll-off.

The epitaxial wafer having a small roll-off can be assuredly manufactured by previously obtaining the correlation between the growth rate and others of the epitaxial layer and a difference between roll-offs before and after epitaxial growth, controlling the growth rate and others based on this correlation, and controlling the roll-off after the epitaxial growth.

It is preferable to control a thickness of the epitaxial layer at a peripheral portion in such a manner that the roll-off of the epitaxial wafer after growth of the epitaxial layer becomes equal to or smaller than the roll-off of the silicon wafer before growth of the epitaxial layer.

Since the roll-off after epitaxial growth can be controlled by controlling the growth rate and others of the epitaxial layer as explained above, the epitaxial wafer having a roll-off equal to or smaller than that of the original silicon wafer can be manufactured.

In this case, the roll-off can be determined as a surface displacement amount from a position where a second order derivative of a surface displacement amount of the silicon wafer or the epitaxial wafer becomes a negative value to a position that is 1 mm inside from an edge of the silicon wafer or the epitaxial wafer.

When the roll-off is controlled as the surface displacement amount in the above-explained range, the outer peripheral shape of the epitaxial layer can be further assuredly controlled, thus manufacturing the epitaxial wafer having a desired roll-off.

As the silicon wafer, a silicon wafer having a diameter of 300 mm or above can be used.

According to the present invention, in particular, the silicon wafer is effective since it has a recently demanded large diameter of 300 mm or above, the epitaxial layer having the excellent film thickness uniformity even near the outer periphery can be formed, and hence diameter reduction chamfering and others do not have to be performed after epitaxial growth. Therefore, when the silicon wafer having a diameter of 300 mm or above is used to grow the epitaxial layer, the epitaxial wafer having a small roll-off value can be manufactured, thus leading to an improvement in a device yield.

Further, according to the present invention, an epitaxial wafer manufactured by the method of the present invention is provided.

As explained above, according to the method of the present invention, the thickness of the epitaxial layer formed at the peripheral portion of the silicon wafer can be controlled, thereby manufacturing the epitaxial wafer having a small roll-off. Therefore, the epitaxial wafer manufactured by such a method has a flatness degree that is high even near the outermost periphery and can improve a device yield.

In particular, there is provided an epitaxial wafer having an epitaxial layer subjected to vapor-phase growth on a silicon wafer, wherein a roll-off of the epitaxial wafer after growth of the epitaxial layer is equal to or smaller than a roll-off of the silicon wafer before growth of the epitaxial layer.

If the epitaxial wafer has the roll-off after epitaxial growth which is equal to or smaller than the roll-off of the original silicon wafer, the film thickness uniformity of the epitaxial layer is excellent even at the periphery, or the flatness degree is high even at the periphery of the epitaxial wafer, thereby assuredly improving a device yield.

In this case, the roll-off can be determined as a surface displacement amount from a position where a second order derivative of a surface displacement amount of the silicon wafer or the epitaxial wafer becomes a negative value to a position that is 1 mm inside from an edge of the silicon wafer or the epitaxial wafer.

In case of the epitaxial wafer whose roll-off is controlled as the surface displacement amount in the above-explained range, the flatness degree is assuredly very high even near the outermost periphery.

The epitaxial wafer can have a diameter of 300 mm or above. In particular, the epitaxial wafer is effective since it has a recently demanded large diameter of 300 mm or above, and diameter reduction processing and others do not have to be performed after epitaxial growth, thus providing the epitaxial wafer having a diameter of 300 mm or above and a small roll-off.

According to the present invention, when manufacturing the epitaxial wafer, controlling the growth rate and/or the growth temperature of the epitaxial layer which is subjected to vapor-phase growth enables controlling the thickness of the epitaxial layer that is formed at the peripheral portion of the silicon wafer. As a result, the epitaxial layer near the outermost periphery can be formed with a large film thickness, thus manufacturing the epitaxial wafer, which has a roll-off equal to or smaller than a roll-off of the silicon wafer before growing the epitaxial layer and also has a very high flatness degree.

### BRIEF DESCRIPTION OF DRAWINGS

Figs. 1 are views schematically showing examples of an outer peripheral shape of an epitaxial wafer according to the present invention, in which (A) corresponds to a case where a roll-off after epitaxial growth is smaller than that before the growth and (B) corresponds to a case where roll-offs before and after epitaxial growth are equal to each other;
Fig. 2 is a schematic view showing an example of a single-wafer processing type epitaxial growth apparatus that can be used in the present invention;
Figs. 3 are graphs each showing roll-off start points before and after epitaxial growth;
Figs. 4 are graphs each showing surface displacement amounts of a peripheral portion before and after epitaxial growth and a difference between the surface displacement amounts before and after growth;
Fig. 5 is a graph showing a relationship between a growth temperature of an epitaxial layer and a difference between roll-off amounts (ΔROA) before and after epitaxial growth;
Fig. 6 is a graph showing a relationship between a growth rate of the epitaxial layer and a difference between roll-off amounts (ΔROA) before and after epitaxial growth;
Fig. 7 is a view for explaining a roll-off start point;
Fig. 8 is a view for explaining a definition of a roll-off;
Fig. 9 is a view showing a sagging shape of the peripheral portion of the wafer;
Fig. 10 is a view showing a sagging shape of the epitaxial layer at the peripheral portion; and
Fig. 11 is a graph showing surface displacement amounts of the silicon wafer and an epitaxial wafer in an example.

### BEST MODE(S) FOR CARRYING OUT THE INVENTION

Manufacturing an epitaxial wafer by using a silicon wafer (a silicon single crystal wafer) according to the present invention will now be specifically explained hereinafter with reference to the accompanying drawings.

The present inventors have repeatedly examined and studied epitaxial growth conditions and an outer peripheral shape of an epitaxial layer when using a silicon wafer to manufacture an epitaxial wafer. As a result, they have discovered that a growth rate and a growth temperature of the epitaxial layer and the outermost peripheral shape of the epitaxial layer have an excellent correlation, and also have revealed that controlling these growth conditions (the growth rate and/or the growth temperature) enables controlling a shape of the epitaxial layer near the outermost periphery to a desired thickness in particular, thereby bringing the present invention to completion.

When manufacturing an epitaxial wafer according to the present invention, a correlation between a growth rate and/or a growth temperature of an epitaxial layer and a difference between roll-offs before and after growth of the epitaxial layer is first obtained.

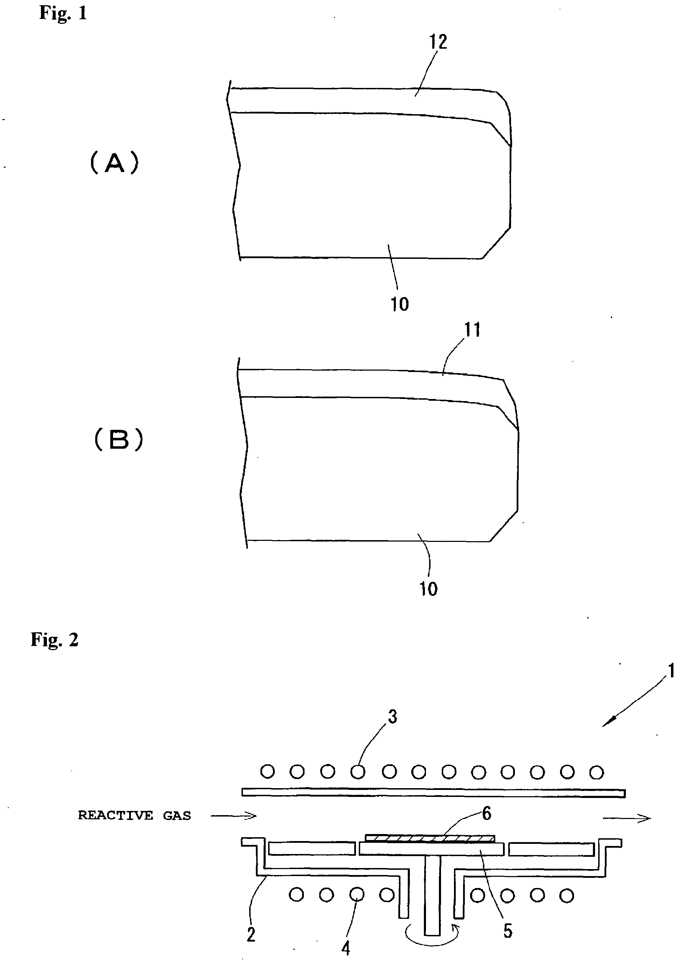

Although an epitaxial growth apparatus is not restricted in particular as long as a growth rate and a growth temperature can be arbitrarily controlled, such a single-wafer processing type epitaxial growth apparatus 1 as shown in Fig. 2 can be preferably used. This apparatus 1 includes heating lamps 3 and 4 above and below a reactor 2, a rotatable susceptor 5, and others. At the time of epitaxial growth, a silicon wafer 6 is mounted on the susceptor 5, a raw material gas such as SiHCl₃ is introduced into the reactor with H₂ as a carrier gas, and the silicon wafer 6 is heated to a predetermined temperature by the upper and lower heating lamps 3 and 4, thereby forming an epitaxial layer having excellent film thickness uniformity on the wafer.

According to such a single-wafer processing type apparatus 1, a growth temperature (a temperature of the wafer) can be highly accurate controlled by using the heating lamps 3 and 4, and a growth rate can be also accurately controlled by adjusting a concentration or a flow quantity of the raw material gas together with a temperature. Further, the single-wafer processing type apparatus 1 can be advantageously used because it can cope with performing epitaxial growth by using a large silicon wafer having a diameter of 200 mm or above, especially 300 mm or above.

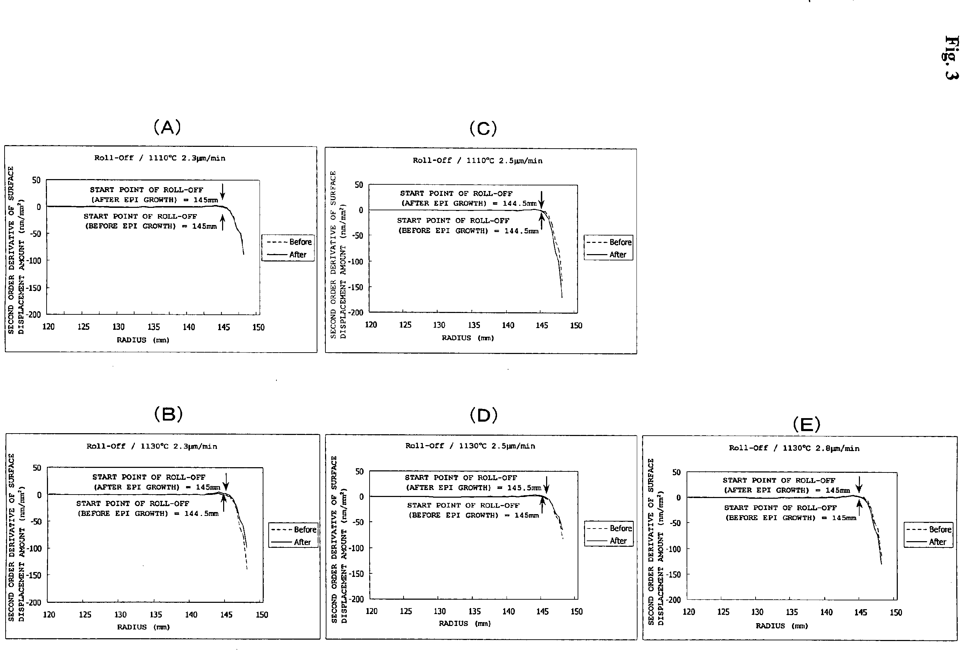

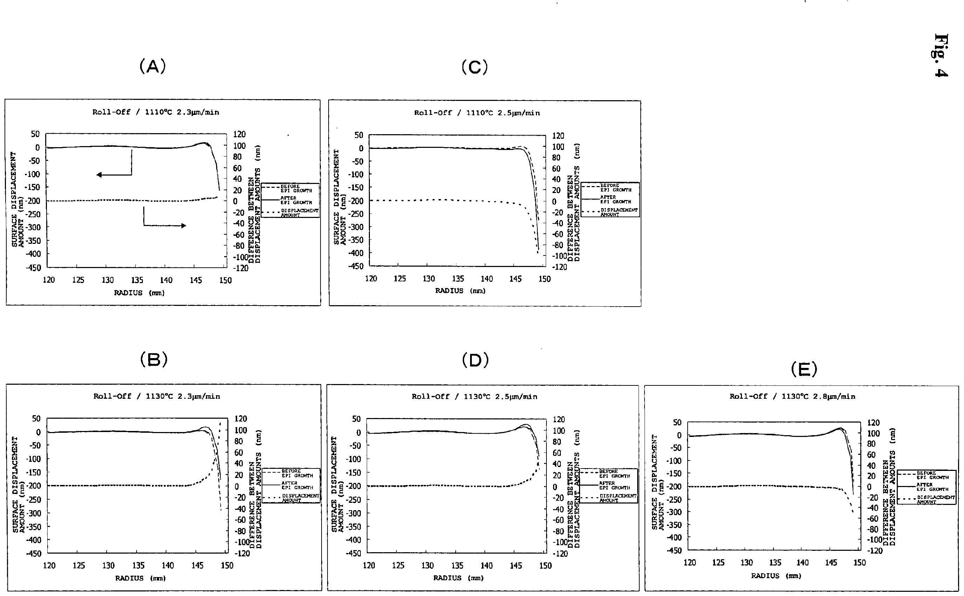

Each of Figs. 3(A) to (E) shows second order derivatives of surface displacement amounts at a wafer peripheral portion before and after epitaxial growth when using a silicon wafer having a diameter of 300 mm to perform epitaxial growth under various growth conditions (the growth rate, the growth temperature) in the form of a graph. Based on Figs. 3, each position where the second order derivative of the surface displacement amount becomes a negative value can be calculated as a roll-off start point. Furthermore, each of Figs. 4(A) to (E) shows surface displacement amounts at the peripheral portion before and after epitaxial growth and a difference between surface displacement amounts before and after growth.

Moreover, a surface displacement amount from the roll-off start point calculated from Figs. 3 to a position that is 1 mm inside from an edge of the wafer is determined as a roll-off, and a difference (ΔROA) between roll-off amounts (ROA) before and after epitaxial growth can be obtained. In Table 1, a relationship between the respective growth conditions and ΔROA is summed up.

**[Table 1]**

| | | GROWTH RATE | | |
|---|---|---|---|---|
| GROWTH TEMPERATURE | | 2.3 µm/min | 2.5 µm/min | 2.8 µm/min |
| 1110°C | ΔROA | 4.87 nm | -88.2 nm | - |
| 1130°C | ΔROA | 93.16 nm | 38.12 nm | -44.23 nm |

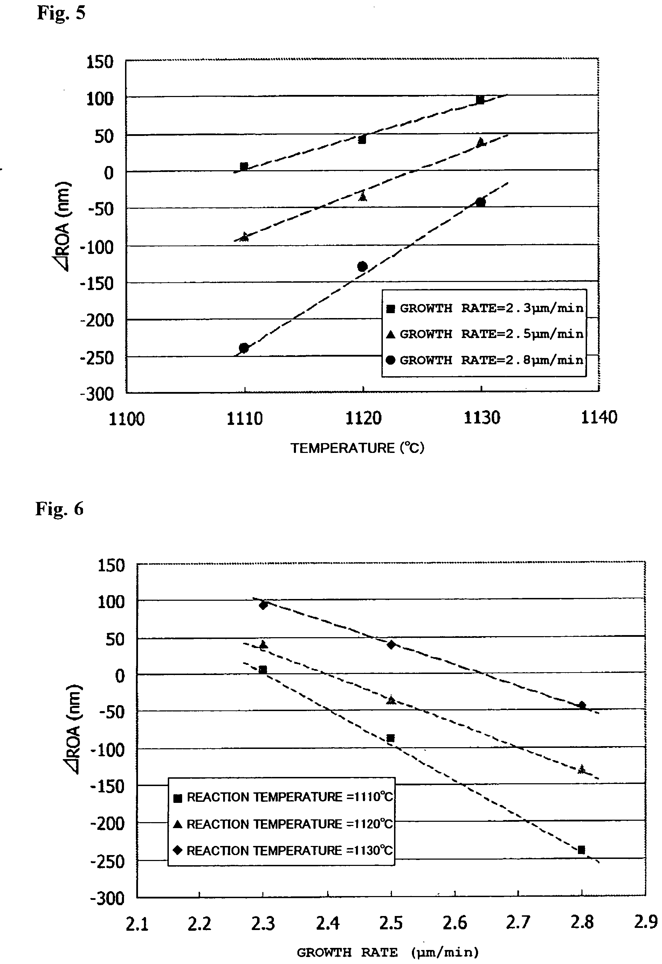

Additionally, ΔROA is likewise obtained with respect to other growth rates and growth temperatures. Each of Figs. 5 and 6 shows a relationship between growth conditions (the growth rate, the growth temperature) of the epitaxial layer and a difference between roll-off amounts before and after epitaxial growth. ΔROA is a value obtained by subtracting a roll-off amount of the silicon wafer before epitaxial growth from a roll-off amount of the epitaxial wafer, a positive value of ΔROA represents that an outer peripheral shape rises in an epitaxial process, whilst a negative value of the same represents that the outer peripheral shape sags in the epitaxial process. Further, when ΔROA is close to 0, this means that a difference between roll-off amounts before and after epitaxial growth is small, i.e., that film thickness uniformity of the epitaxial layer is high near the outermost periphery.

In each of Figs. 5 and 6, excellent correlations can be observed between the growth temperature and ΔROA and between the growth rate and ΔROA. That is, according to Fig. 5, when the growth rate is fixed, ΔROA rises and the thickness of the epitaxial layer at the periphery can be enlarged as the growth temperature is increased. Furthermore, when the growth temperature remains the same, it can be understood that ΔROA is increased and a shape that the epitaxial layer has a large thickness at the outermost peripheral portion can be obtained as the growth rate is reduced.

On the other hand, according to Fig. 6, when the growth temperature is fixed, ΔROA is reduced and the thickness of the epitaxial layer at the periphery is reduced as the growth rate is increased. Moreover, when the growth rate remains the same, it can be understood that ΔROA is increased and a shape that the epitaxial layer has a large thickness near the outermost periphery after epitaxial growth can be obtained as the growth temperature is increased.

Thus, based on these correlations, controlling the growth rate and/or the growth temperature of the epitaxial layer that is grown on the silicon wafer as a product enables controlling a roll-off after growth of the epitaxial layer. That is, when the growth temperature and the growth rate are individually controlled or they are appropriately combined to be controlled, the outer peripheral shape of the epitaxial layer can be controlled, and the thickness of the epitaxial layer can be controlled in such a manner that the roll-off of the epitaxial wafer after growth of the epitaxial layer become equal to or smaller than the roll-off the silicon wafer before growth of the epitaxial layer.

That is, when the roll-off the silicon wafer is measured in advance and growth conditions of the epitaxial layer are set so as to cancel out this value, the epitaxial wafer that is flat to the peripheral portion can be obtained, thereby manufacturing the epitaxial wafer having a shape in which the epitaxial layer 12 is thick at the outer peripheral portion as depicted in Fig. 1(A). On the other hand, when growth conditions are set in such a manner that the previously measured roll-off value of the silicon wafer remains the same, the epitaxial wafer having the epitaxial layer whose film thickness is uniform even at the periphery, e.g., an epitaxial wafer in which the thickness of the epitaxial layer 11 is uniform even at the outermost peripheral portion as shown in Fig. 1(B) can be obtained.

As a specific example, when using a silicon wafer sagging at a peripheral portion to manufacture an epitaxial wafer, in order to intentionally rise an outer peripheral shape of an epitaxial layer, it is good enough to perform epitaxial growth under growth conditions where a growth temperature is 1130°C or above and a growth rate is 2.5 µm/min or below based on the relationship depicted in Fig. 5. Performing epitaxial growth under such growth conditions enables increasing a thickness of the epitaxial layer at a peripheral portion, thereby manufacturing the epitaxial wafer whose outer peripheral shape is substantially flat. It is to be noted that, even when the growth temperature is a lower temperature, e.g., 1110°C or below, reducing the growth rate enables demonstrating the same effect. Therefore, it is good enough to appropriately set the growth temperature and the growth rate while considering the outer peripheral shape of the silicon wafer before epitaxial growth, the outer peripheral shape that is desired after epitaxial growth, productivity, and others.

An example of the present invention will now be explained.

### (Example)

A silicon wafer having a diameter of 300 mm was prepared, and DynaSearch (manufactured by Raytex Corporation) was used as a flatness/nanotopography measurement apparatus to measure a height displacement amount of a surface at a wafer peripheral portion, and a measured value was determined as a roll-off amount.

In order to compensate a sagging shape of the peripheral portion when performing epitaxial growth with respect to this wafer, a growth temperature was set to 1130°C and a growth rate was set to 2.5 µm/min based on the correlations depicted in Figs. 5 and 6 to perform epitaxial growth. Further, a surface displacement amount of the manufactured epitaxial wafer was measured like the silicon wafer before epitaxial growth.

Fig. 11 shows surface displacement amounts of the silicon wafer and the epitaxial wafer, in which an ordinate represents a value of a second order derivative of the surface displacement amount and an abscissa represents a distance (a radius) from the center (0 mm) of the wafer. A precipitous drop of a value to be a negative value at the outer peripheral portion means that the shape is sagging, and a rise of the same to be a positive value means that the shape is rising.

As shown in Fig. 11, when a second order derivative of each displacement amount is obtained with a radial distance, an accelerated change in displacement amount with respect to the radius appears.
A position where the second order derivative of the surface displacement amount becomes a negative value, i.e., a roll-off start point is 145 mm from the center of the silicon wafer before epitaxial growth or 145.5 mm from the center of the epitaxial wafer after epitaxial growth. Based on this, it can be understood that the roll-off start point is shifted toward the outer peripheral side of the wafer due to epitaxial growth. Further, in this example, a roll-off amount from the roll-off start point to a position that is 1 mm inside from an edge of the wafer is 356 nm before epitaxial growth or 322 nm after epitaxial growth, and it can be understood that the outer periphery sagging shape of the wafer was complemented by piling up the epitaxial layer.

It is to be noted that the present invention is not restricted to the foregoing example. The foregoing example is just an exemplification, and any example which has substantially the same structure as technical concepts explained in claims according to the present invention and demonstrates the same functions and effects is included in the technical scope of the present invention.

For example, using the single-wafer processing type epitaxial apparatus to perform epitaxial growth has been explained, but the apparatus that can be used is not restricted to this type, and an apparatus of any other type, e.g., a batch type, a cylinder type, or a pancake type can be used as long as a growth rate and a growth temperature of an epitaxial layer can be appropriately controlled.

Furthermore, a size of the silicon wafer is not restricted to 300 mm, and appropriately selecting the size of the wafer in accordance with requirements can suffice.

## Claims

1. A method for manufacturing an epitaxial wafer by supplying a raw material gas onto a silicon wafer to perform vapor-phase growth of an epitaxial layer, wherein a correlation between a growth rate and/or a growth temperature of the epitaxial layer and a difference between roll-offs before and after growth of the epitaxial layer is obtained in advance, and a roll-off after growth of the epitaxial layer is controlled by controlling the growth rate and/or the growth temperature of the epitaxial layer that is grown on the silicon wafer to be a product based on the correlation, wherein the roll-off is a surface displacement amount from a position where a second order derivative of a surface displacement amount of the silicon wafer or the epitaxial wafer becomes a negative value to a position that is 1 mm inside from an edge of the silicon wafer or the epitaxial wafer.

2. The method for manufacturing an epitaxial wafer according to claim 1, wherein a thickness of the epitaxial layer at a peripheral portion is controlled in such a manner that the roll-off of the epitaxial wafer after growth of the epitaxial layer becomes equal to or smaller than the roll-off of the silicon wafer before growth of the epitaxial layer.

3. The method for manufacturing an epitaxial wafer according to claim 1 or 2, wherein a silicon wafer having a diameter of 300 mm or above is used as the silicon wafer.

## Patentansprüche

1. Verfahren zur Herstellung eines Epitaxialwafers durch Zufuhr von Rohmaterialgas auf einen Siliciumwafer, um Gas-Phasen-Wachstum einer Epitaxialschicht durchzuführen, wobei im Voraus eine Korrelation zwischen einer Wachstumsrate und/oder einer Wachstumstemperatur der Epitaxialschicht und eine Differenz zwischen Roll-offs vor und nach Wachstum der Epitaxialschicht erhalten wird, und ein Roll-off nach dem Wachstum der Epitaxialschicht wird dadurch kontrolliert, dass die Wachstumsrate und/oder die Wachstumstemperatur der Epitaxialschicht, die auf dem Siliciumwafer aufwächst, kontrolliert wird, so dass ein Produkt basierend auf der Korrelation erhalten wird, wobei der Roll-off eine Oberflächenabtragmenge ist von einer Position, wo eine zweite Ableitung der Oberflächenabtragmenge des Siliciumwafers oder des Epitaxialwafers einen negativen Wert einnimmt, bis zu einer Position, die 1 mm innerhalb von einer Kante des Siliciumwafers oder des Epitaxialwafers ist.

2. Verfahren zur Herstellung eines Epitaxialwafers nach Anspruch 1, worin eine Dicke der Epitaxialschicht in einem Außenbereich in einer solchen Weise kontrolliert wird, dass der Roll-off des Epitaxialwafers nach dem Wachstum der Epitaxialschicht gleich oder kleiner wird als der Roll-off des Siliciumwafers vor dem Wachstum der Epitaxialschicht.

3. Verfahren zur Herstellung eines Epitaxialwafers nach Anspruch 1 oder 2, worin ein Siliciumwafer mit einem Durchmesser von 300 mm oder darüber als der Siliciumwafer verwendet wird.

## Revendications

1. Procédé de fabrication d'une plaquette épitaxiale par alimentation d'un gaz matière première sur une plaquette de silicium pour réaliser une croissance en phase vapeur d'une couche épitaxiale, dans lequel une corrélation entre une vitesse de croissance et/ou une température de croissance de la couche épitaxiale et une différence entre les enroulements avant et après la croissance de la couche épitaxiale est obtenue à l'avance, et un enroulement après croissance de la couche épitaxiale est régulé en régulant la vitesse de croissance et/ou la température de croissance de la couche épitaxiale qui croît sur la plaquette de silicium pour être un produit basé sur la corrélation, dans lequel l'enroulement est une quantité de déplacement de surface d'une position où une dérivée du second ordre d'une quantité de déplacement de surface de la plaquette de silicium ou de la plaquette épitaxiale devient négative à une position qui est 1 mm à l'intérieur à partir d'un bord de la plaquette de silicium ou de la plaquette épitaxiale.

2. Procédé de fabrication d'une plaquette épitaxiale selon la revendication 1, dans lequel une épaisseur de la couche épitaxiale au niveau d'une partie périphérique est régulée de manière à ce que l'enroulement de la plaquette épitaxiale après croissance de la couche épitaxiale soit inférieur ou égal à l'enroulement de la plaquette de silicium avant la croissance de la couche épitaxiale.

3. Procédé de fabrication d'une plaquette épitaxiale selon la revendication 1 ou 2, dans lequel une plaquette de silicium ayant un diamètre de 300 mm ou plus est utilisée comme plaquette de silicium.
